# EUROPEAN PATENT APPLICATION

(11) **EP 3 598 853 A1**
(43) Date of publication of application: **22.01.2020**
(21) Application number: 18184863.1
(22) Date of filing: 20.07.2018
(51) Int. Cl.: H05K 1/02

(54) **SENSOR DEVICE WITH TRACKABLE MARKING**

(71) Applicant: Sensirion Automotive Solutions AG, 8712 Stäfa ZH (CH)
(72) Inventor: HOPPENAU, Lukas, 8712 Staefa ZH (CH); PUSTAN, David, 8712 Staefa ZH (CH)
(74) Representative: Schulz Junghans Patentanwälte PartGmbB

(57) **Abstract**

The invention relates to a sensor device (1) which comprises a circuit board (50) and at least one sensor (52) arranged on the circuit board (50). Further, the sensor device (1) comprises a housing (20) wherein the housing (20) comprises at least a first opening (30). The circuit board (50) comprises a marking (40), wherein the marking (40) codes information, and wherein the at least one first opening (30) is configured and arranged such that it leaves the marking (40) uncovered by the housing (20) such that the marking (40) is visible from outside of the housing (20) through the at least one first opening (30).

## Description

The present invention relates to a sensor device that comprises a marking that codes information related to the respective sensor device.

Sensor devices of the afore-mentioned kind usually comprise a circuit board to carry electronic components of the sensor device such as e.g. a particular sensor. In order to protect the electronic components, the circuit board (and the components thereon) can be encapsulated by a housing. The housing then protects the circuit board and electronic component thereon against environmental, mechanical and/or chemical stresses. Further, the housing determines the final appearance and form of the sensor device.

Relevant production information related to the sensor device is usually linked to a marking provided on the sensor device. Such production information also referred to as production parameters, can comprise information about the supplier, origin and the date of assembly of the sensor device. Assembly of a sensor device may comprise the assembly of electronic components on the circuit board and/or the assembly of the housing.

Due to the marking, a sensor device of the afore-mentioned kind can be tracked during each step of the production process and the device may e.g. be processed according to the information provided by the marking.

Further, by means of the marking on the final sensor device, it is possible to gain information about the specific production parameters. This can be of interest when associating the persistence and/or performance of the respective sensor device to the used electronic components.

To achieve both a visible marking during the production process and a visible marking on the final product, state of the art sensor devices are configured such that a first marking is arranged on the circuit board such that the first marking is visible during the production process. This first marking becomes invisible when the circuit board is encapsulated by a housing. Then the housing is marked with a second marking, wherein the second marking is linked to the first marking. For instance, the first and the second marking are connected via a database.

However, incorrect assignments between the first and the second marking are possible such that no correct matching is made. Further, additional production steps are necessary prolonging the production process and requiring additional equipment. This particularly includes the application of the second marking or the administration of the database.

Furthermore, state of the art sensor devices that comprise a second marking on the housing have the disadvantage that the second marking is unprotected and may not be durable against abrasion. In particular, a second marking that is arranged on a housing that consists of a hot melt component is not durable against abrasion. As a consequence, a long-lasting trackability of sensor devices comprising such markings is not assured. Another issue is that a marking which is embossed in the housing might disappear or becomes unreadable due to deformation of the material.

Thus, based on the above, the problem to be solved by the present invention is to provide a sensor device that is improved regarding at least some of the above-stated difficulties.

This problem is solved by a sensor device having the features of claim 1. Further aspects of the present invention relate to a method for producing a sensor device as well as to a method for tracking a sensor device. Embodiments of the respective aspect of the present invention are stated in the corresponding sub claims and are described below.

According to claim 1, sensor device is disclosed, comprising a printed circuit board, at least one sensor arranged on the printed circuit board, and a housing covering (particularly enclosing) at least a part of the printed circuit board.

According to the present invention, the printed circuit board comprises a marking representing information, wherein the marking is arranged in a marking area on a surface of the printed circuit board, and wherein the housing comprises at least a first opening designed such that the marking is visible from an outside of the housing through the at least one first opening, and wherein the at least one first opening defines an area along an outside of the housing that is smaller than ten times the marking area or that is equal to ten times the marking area.

Particularly, in an embodiment, the marking area corresponds to an area that is defined as the product of a width along which the entire marking extends in a first direction and a height along which the entire marking extends in a second direction that is orthogonal to the first direction.

In other words, particularly, the at least one first opening is configured and arranged such that it leaves the marking uncovered by the housing such that the marking is visible from an outside of the housing through the at least one first opening.

Furthermore, in an embodiment, the at least one first opening defines an area along an outside of the housing that is smaller than five times the marking area or that is equal to five times the marking area. Furthermore, preferably, the at least one first opening defines an area along an outside of the housing that is smaller than three times the marking area or that is equal to three times the marking area.

Particularly, in an embodiment, Information coded by the marking can comprise at least one of: production information related to the sensor device, information about a supplier of a component of the sensor device, an origin of the sensor device, a date of an assembly of the sensor device.

Particularly, according to the present invention, the marking is arranged on the circuit board and visible from an outside of the housing even in the case of the final, i.e. fully assembled sensor device. It is thus not necessary to arrange a marking on the housing to have access to the relevant production information provided by the marking. Furthermore, the marking on the circuit board is more durable than a marking on an outside of the housing, since the marking on the circuit board comprises a better protection against abrasion due to the housing itself.

Since the marking is visible on the final sensor device it is not necessary to provide a second marking (see above) and to associate it to a first marking, which reduces the risk for an erroneous marking.

Further, since the second marking can be omitted, the production process and related tracking is more cost effective.

Particularly, the at least one first opening forms a through-opening. This means that the at least one first opening particularly extends from an outer surface of the housing to an inner side of the housing that faces and particularly covers or encloses the circuit board.

In particular, the housing is configured and arranged to protect the circuit board and the at least one sensor arranged thereon (as well as particularly other components arranged on the circuit board) against external influences, such as chemical stress, environmental influences or mechanical damages.

In an embodiment, the at least one first opening is configured and arranged such that the marking is visible from an area facing a surface of the circuit board, on which surface the marking is arranged, in a direction normal to said surface.

In particular, the marking is visible from a viewing position that is located in front of the circuit board outside the housing along a direction normal to the circuit board (particularly normal to said surface of the circuit board).

Thus, due to the fact that the entire marking is visible from an outside of the housing all information coded by the marking is advantageously accessible from outside of the housing. Furthermore, according to an embodiment of the sensor device according to the present invention, the housing comprises or is formed out of a non-transparent material.

Furthermore, according to an embodiment, at least a portion of the housing is formed out of a filling compound, wherein said at least one opening of the housing is formed in said portion of the housing. Particularly, said filling compound is a non-transparent filling compound. Particularly, the (non-transparent) material or filling compound is a solid material that is configured to fulfil a protective function such that it can protect the circuit board from chemical, environmental and/or mechanical stresses (see also above).

Various embodiments are conceivable for the filling compound. Preferably, in an embodiment of the present invention, the filling compound is a hot melt, e.g. Henkel Technomelt PA 6771 or Bostik Thermelt 181, or a UV-curable adhesive. Such materials have the advantage that they do not have to be applied under high pressure and thus allow to avoid damage to the sensor during casting/forming of the housing. But also other adhesives, casting compounds or resins may be used as materials / filling compounds. For example, conventional injection molding compounds may be used.

Furthermore, the filling compound or material of the housing can comprise one of: a plastic, a polymer, a polyamide.

Particularly, the hot melt can be a hot melt comprising a polyamide.

In a further embodiment of the sensor device according to the present invention, the at least one first opening is configured and arranged such that it leaves the marking as well as the at least one sensor uncovered by the housing, particularly by said portion of the housing, such that the marking and the at least one senor are visible or accessible, respectively, from an outside of the housing through the at least one first opening. In other words, the at least one first opening is designed such that the at least one sensor is in communication with an outside atmosphere surrounding the housing through the at least one first opening. In this way, the at least one sensor can measure a temperature and/or a humidity and/or a gas concentration in the vicinity of the sensor device.

Particularly, according to an embodiment, the marking and the at least one sensor are arranged adjacent to one other. In this case, the at least one first opening can provide contact of the at least one sensor with the ambient atmosphere as well as an optical path to the marking. Thus, a further opening of the housing can be omitted and the circuit board can be effectively covered and protected against external stresses by the housing.

According to an alternative embodiment of the sensor device, the housing comprises a second opening (particularly in the form of a through-opening, see above), wherein the second opening can also be formed in said portion of the housing and is preferably configured and arranged such that it leaves the at least one sensor uncovered by the housing such that the at least one sensor can communicate with an outside of the housing through the second opening. Thus, in this embodiment, the housing comprises two different openings, wherein one opening is associated to the marking and the other one to the at least one sensor.

Due to the fact that the marking and the at least one senor are related to separate (individual) openings, the marking and the at least one sensor can be arranged with more flexibility of the circuit board.

Further, according to an embodiment of the sensor device, the housing comprises a first side and a second side, wherein the first side and the second side face away from each other. Particularly, the first side can be a front side or a back side of the housing. Furthermore, correspondingly, the second side can be a back side or a front side of the housing.

According to an embodiment, the first (e.g. front or back) side of the housing comprises the at least one first opening and/or the second opening.

Furthermore, according to a further embodiment, the first (e.g. front or back) side of the housing comprises the at least one first opening, whereas the second (e.g. back or front) side comprises the second opening. Hence, in this embodiment, the at least one sensor and the marking are accessible from different directions, in particular from opposite directions.

According to a further embodiment, that the at least one first opening and the second opening are aligned with one another, particularly with respect to a direction extending perpendicular to the printed circuit board of the sensor device (or perpendicular to the first and second sides of the housing).

Alternatively, the at least one first opening and the second opening can also be arranged on opposing sides of the housing, but offset with respect to one another.

Further, according to a preferred embodiment of the present invention the at least one sensor is configured to measure a humidity and/or a temperature of a gas, particularly air, and/or a gas concentration in the vicinity of the sensor device.

Further, according to an embodiment of the present invention, the marking is a machine-readable marking, e.g. a marking that can be read and particularly interpreted by an (e.g. programmable) device comprising an optical component for detecting the marking. Hence, the marking particularly allows to track the sensor device automatically (e.g. during all stages of assembly of the sensor device once the marking is provided on the printed circuit board).

Further, according to an embodiment of the sensor device according to the present invention, the marking comprises an alphanumerical character and/or a one-dimensional code, in particular a bar code.

Particularly, an alphanumerical character can be a number, an alphabetic character or a special character or symbol.

Particularly, a one-dimensional code is also referred to as linear code. In particular, a bar code encodes data by parallel lines wherein the individual parallel lines may vary in their width and the distance between adjacent lines.

According to the invention the marking may comprise a combination of a one-dimensional code and an alphanumeric character.

According to a further embodiment, the marking comprises a two-dimensional code. In particular, the marking comprises a matrix code, also referred to as two-dimensional bar code.

A two-dimensional code can for instance be a data matrix code, or a Quick Response (QR) code.

Furthermore, according to an embodiment of the present invention, the marking may comprise any combination of a one-dimensional code, a two-dimensional code and an alphanumeric character.

Further, according to an embodiment, at least a part of the marking (or all of the marking) is generated by use of a laser, e.g. cut into the surface of the printed circuit board by means of the laser. Particularly, by use of a laser, the marking can be positioned exactly. Advantageously, a marking generated by means of a laser is very durable.

Furthermore, according to yet another embodiment of the sensor device according to the present invention, the sensor device comprises a cover element wherein the cover element is arranged in or covers the at least one first opening. Particularly, the cover element comprises or is formed of a transparent material such that the marking is visible from an outside of the housing through the cover element (and the first opening). However, according to a preferred embodiment, the at least one first opening is not covered or closed by an element (e.g. cover element).

Particularly, said transparent material can be a solid material that can be configured to fulfil a protective function. In particular, the transparent material can be one of: a plastic, a polymer, an adhesive, a UV curable material, a potting material, a hot melt (see also above) and/or an injection molding compound.

Particularly, the cover element may completely or partially fill the at least one first opening.

An advantage of this embodiment is that the marking is still visible from an outside the housing through the first opening and the cover element while the circuit board is completely protected in this area.

Furthermore, according to an embodiment, the housing can comprise a first part and a second part, wherein the first part comprising a section of the first side and a section of the second side of the housing is formed out of a hot melt, and wherein the second part comprising a section of the first side and a section of the second side of the housing is an injection-molded second part of the housing.

Particularly, the first opening can be formed in the first part or in the second part of the housing. Furthermore, particularly, the second opening can be formed in the first part or in the second part of the housing. Particularly, the two openings can have the configurations described above concerning their arrangement with respect to one another (aligned or offset).

Furthermore, according to an embodiment of the sensor device according to the present invention, the printed circuit board comprises a first side (e.g. front side) and a second side (e.g. back side) facing away from the first side, wherein the at least one sensor and the marking are arranged on the first side (e.g. front side), and wherein the housing covers the first side of the printed circuit board, wherein particularly the second side (e.g. back side) of the printed circuit board is not covered by the housing, i.e., the second side of the printed circuit board forms a back side of the housing. According to an alternative embodiment, the housing covers both the first and the second side of the printed circuit board. In these two alternative embodiments, the housing is particularly an injection-molded housing.

Particularly, the first part of the housing can be formed as a protrusion (also denoted as finger) protruding (e.g. along an axis, e.g. longitudinal axis) from the second part of the housing, which second part comprises a larger diameter in a direction perpendicular to said axis than the first part (protrusion or finger). Particularly, the first part is configured such that it can be released from the second part.

A further aspect of the present invention is directed to a method for producing a sensor device, particularly a sensor device according to the present invention, wherein this method comprises the steps of:
- providing a printed circuit board comprising a marking that codes an information,
- arranging at least one sensor on the printed circuit board, and
- covering at least a part of the printed circuit board with a housing comprising at least a first opening such that the marking is visible from an outside of the housing through the at least one first opening.

Particularly, according to an embodiment of the method, the circuit board comprises a front side and a back side, wherein the front side and the back side of the circuit board face away from each other, and wherein the marking is arranged on the back side of the circuit board, and wherein the at least one sensor is arranged on the front side of the circuit board.

Furthermore, according to an embodiment of the method, at least a portion of the housing is formed in a mold process out of a mold material (e.g. filling compound), wherein preferably the at least one first opening is defined by a first mold tool stamp and/or wherein preferably the second opening is defined by a second mold tool stamp. Preferably, the mold material is a hot melt. However also other suitable materials may be used instead of the hot melt (see e.g. above).

Particularly, in an embodiment the printed circuit board may be held or may be arranged between the first mold tool stamp and the second mold tool stamp (acting e.g. as counter holder to the first mold tool stamp) such that the first mold tool stamp covers the marking (particularly the marking area) and such that the second mold tool stamp covers said at least one sensor, and wherein the mold material (preferably hot melt) is arranged on the circuit board in a molten state and cured to form at least a portion of the housing, wherein particularly the first mold tool stamp forms a first mold for forming the at least one first opening, and wherein the second mold tool stamp forms a second mold for forming the second opening, and wherein particularly the mold tool stamps are removed of the housing after forming of said portion of the housing.

Yet another aspect of the present invention is directed to a method for tracking a sensor device according to the present invention, wherein the marking of the sensor device is read during production of the sensor device by at least one optical device.

Since the marking is visible from an outside of the housing through the at least one first opening of the housing, the marking can easily be read during the production process such that each individual sensor device can be tracked during assembly. This may give information about the work load that can be used to use the full capacity of the production pipeline.

Furthermore, the fact that the marking of the final sensor device can be read out is of particular advantage because production parameters can be easily accessed. For instance, this simplifies the comparison of the persistence and/or performance of used electronic components. For example, in warranty cases it is easy to find out which components have been used without having to disassemble the whole sensor device.

In the following, further features, advantages and embodiments of the present invention are explained with reference to the Figures, wherein
- Fig. 1A: shows a plan view onto a first side of a housing of an embodiment of a sensor device according to the present invention, the sensor device comprising a marking that comprises a two-dimensional code,
- Fig. 1B: shows a plan view onto a first side of a housing of an embodiment of a sensor device according to the present invention, the sensor device comprising a marking that comprises an alphanumerical character,
- Fig. 1C: shows a plan view onto a first side of a housing of an embodiment of a sensor device according to the present invention, the sensor device comprising a marking that comprises a two-dimensional code,
- Fig. 1D: shows a plan view onto a second side of a housing of an embodiment of a sensor device according to the present invention,
- Fig. 1E: shows a plan view onto a second side of a housing of an embodiment of a sensor device according to the present invention,
- Fig. 2: shows a perspective view of the first side of the housing of the sensor device of Fig. 1A,
- Fig. 3: shows a plan view onto a first side of a housing of an embodiment of a sensor device according to the present invention comprising a finger and a marking, wherein the marking is arranged on the finger, and
- Fig. 4: shows a plan view onto a first side of an embodiment of a sensor device according to the present invention comprising a finger, wherein the sensor is arranged on the finger and the marking is arranged on a base body of the sensor device.

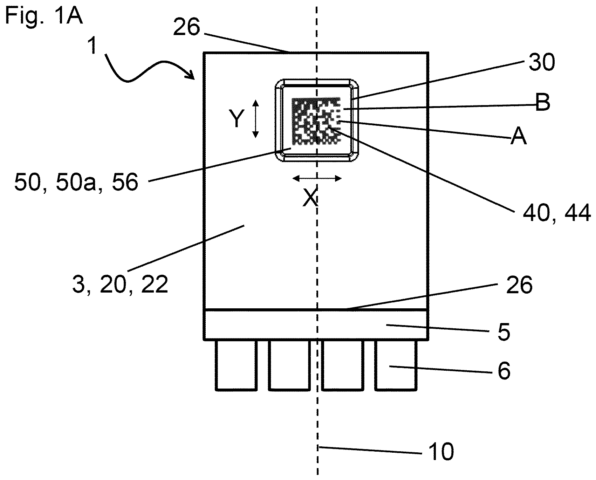

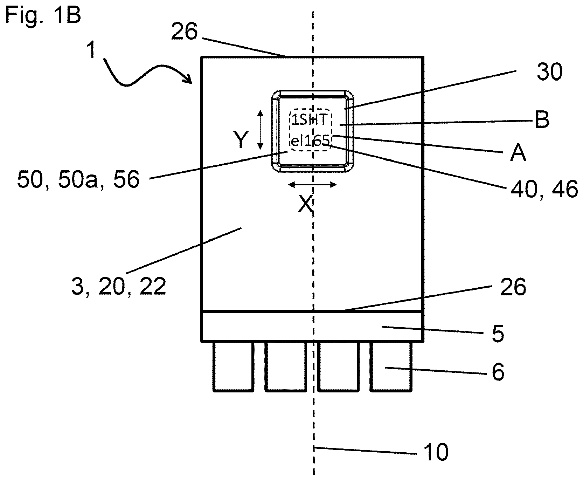

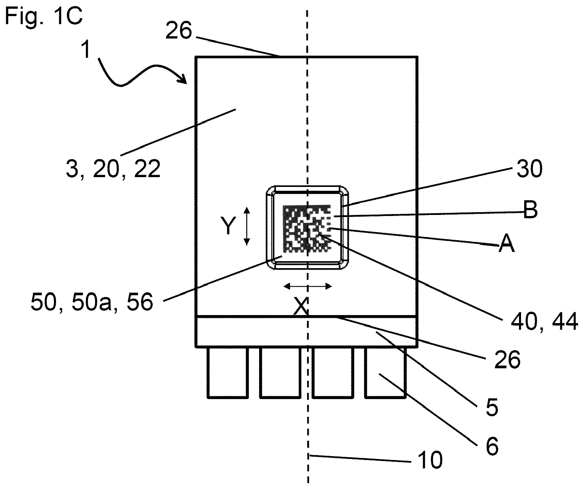

Figures 1A, B and C, show different embodiments of a sensor device 1 according to the present invention. The respective sensor device 1 comprise a circuit board 50 enclosed by a housing 20. The housing 20 may be formed out of a filling compound, wherein the filling compound preferably is a hot melt (e.g. Henkel Technomelt PA 6771 or Bostik Thermelt 181). Furthermore, the filling compound can also be a UV-curable adhesive or a material that is suitable for injection molding. Particularly, Figs. 1A, 1B, and 1C show a plan view onto a first side 22 of the housing 20 which is particularly a back side 22 of the respective housing 20.

In the embodiments shown in Figs. 1A, 1B, and 1C, the housing 20 of the sensor device 1 extends along a central axis 10 and comprises a base section 3 that may comprise a rectangular shape or a rounded rectangular shape, as well as a connecting section 5 comprising electrical contacts 6 for connecting the sensor device 1 to another component receiving an output signal of the sensor device 1. The connecting section 5 can protrude from a lateral wall 26 of the base section 3, which lateral wall connects the first side 22 with a second (front) side 24 of the device 1.

Particularly, the housing 20 of the respective devices 1 shown in Figs. 1A, 1B and 1C comprises on the first side 22 (here e.g. back side 22) a first opening 30 through which a marking 40 arranged on a surface 50a of the circuit board 50, in particular on the back side 56 of the circuit board 50, is visible. Particularly, the marking 40 comprises a two-dimensional extension and thus occupies a marking area A that comprises a width X in a first direction and a height Y in a second orthogonal direction. Preferably, in order to ensure proper protection of the device 1, an area B defined by the at least one opening 30 is smaller or equal to ten times, particularly five times, particularly three times, said marking area A.

Particularly, visibility of the marking 40 is achieved by forming the respective opening 30 such that the marking 40 is not covered by the housing 20 and allows detection of the marking 40 arranged on the printed circuit board 50. Consequently, all information coded in the marking 40 can easily be accessed from outside.

Particularly, the first opening 30 can have a circular or a rectangular boundary on the first side 22 of the housing 20. A rectangular boundary may have rounded corners.

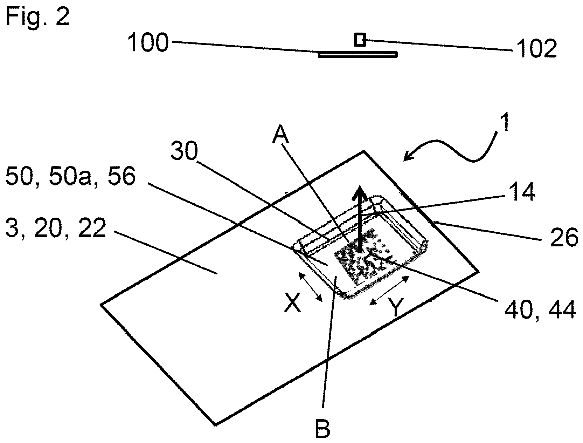

As indicated in Fig. 2 as an example, the first opening 30 is particularly formed such in relation to the marking 40 that the latter is visible from a viewing position 102 within a certain area 100 facing the marking 40 in a direction of a normal 14 to the marking 40 or to the printed circuit board 50.

Particularly, the first opening 30 can be positioned on the first side 22 of the housing 20 above the central axis 10. Further, the first opening 30 can be located on an end section of the housing 20 / sensor device 1 opposite the connecting section 5 as shown in Fig. 1A or Fig. 1B. Furthermore, as shown in Fig. 1C, the first opening 30 can also be arranged in proximity to the connecting section 5.

In particular, the marking 40 can be applied to the circuit board 50 by means of a laser. Laser marking is a widely-used and industry-proven method that generates durable markings.

Particularly, the respective marking 40 codes information, in particular machine-readable information. The coded information particularly comprises relevant production information such as e.g. information about a supplier of a component of the sensor device or a date of assembly of the respective sensor device 1.

Fig. 1A and Fig. 1C each show an embodiment in which the marking 40 is a two-dimensional code 44. A two-dimensional code 44 can for instance be a 2D matrix code.

According to Fig. 1B the marking 40 can also comprise one or several alphanumeric characters 46. An alphanumerical character 46 may be a character, a number, and particularly also another symbol. The respective marking 40 can be formed out of any suitable combination of a one-dimensional code, a two-dimensional code 44 and an alphanumeric character 46.

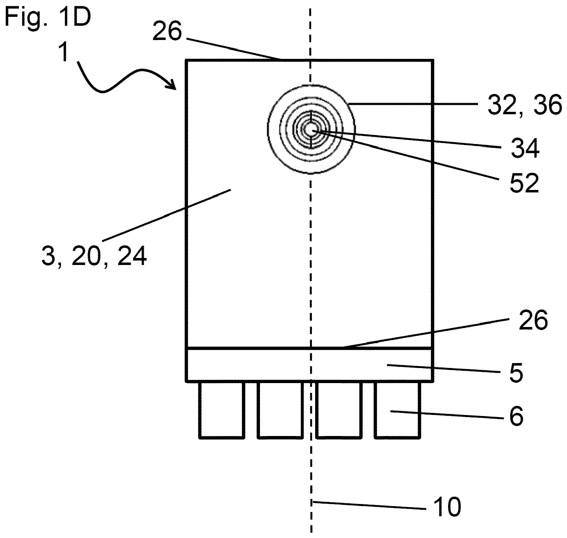

In Fig. 1D an opposite second side (e.g. a front side) of the respective housing 20 of Figs. 1A, 1B or 1C is shown. Here, the second side 24 of the housing 20 comprises a second opening 32 via which a sensor 52 arranged on the printed circuit board, in particular on the front side 54 of the printed circuit board 50, is in contact with a surrounding atmosphere, so that the sensor 52 can measure e.g. a humidity and/or temperature of a gas, particularly air, in the vicinity of the sensor device 1.

Furthermore, in an embodiment, the second opening 32 can comprise an inner (e.g. circular) boundary or edge 34 wherein an inner diameter of the second opening 32 increases towards the second side 24 of the housing 20, where the second opening 32 comprises an outer (e.g. circular) boundary 36. Thus, the second opening 32 may comprise a conical shape tapering towards the sensor 52.

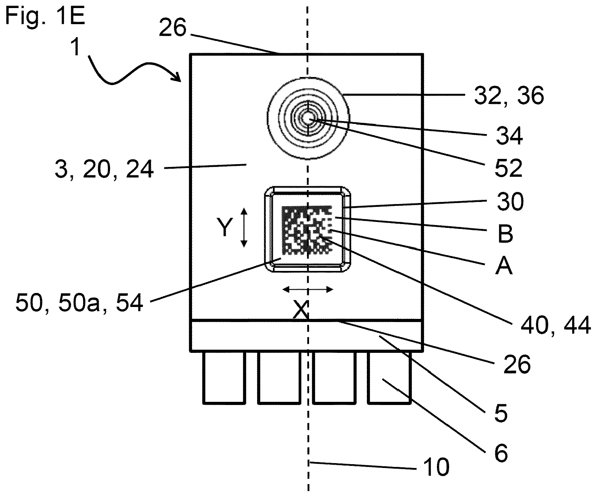

Fig. 1E shows an alternative embodiment, wherein both openings 30, 32 are arranged side by side on the second side (here e.g. front side) 24 of the housing 20 of the device 1. Here, particularly, the sensor 52 and the marking 40 are arranged (e.g. side by side) on a front side 54 of the printed circuit board 50.

Also here, both openings 30, 32 can be arranged above the central axis 10.

Furthermore, in case the two openings 30, 32 are arranged on opposing sides 22, 24 of the housing 20 that face away from one another, the two openings 30, 32 can be aligned with one another as indicated by Figs. 1A and 1B in case of side 22 and Fig. 1D in case of the other side 24. Such a configuration is particularly advantageous in case the housing 20 is formed out of a hot meld compound using stamps to hold the circuit board 50, wherein the stamps form those regions where the openings 30, 32 are located after curing of the housing 20. The alignment of the openings 30, 32 / stamps is beneficial because it allows holding the circuit board 50 during forming of the housing 20 using only two contact points on either side 52, 54 of the printed circuit board 50.

However, as indicated by Figs. 1C on the one hand and Fig. 1D on the other hand, both openings 30, 32 can be arranged offset with respect to each other on the different sides 22, 24 of the housing 20.

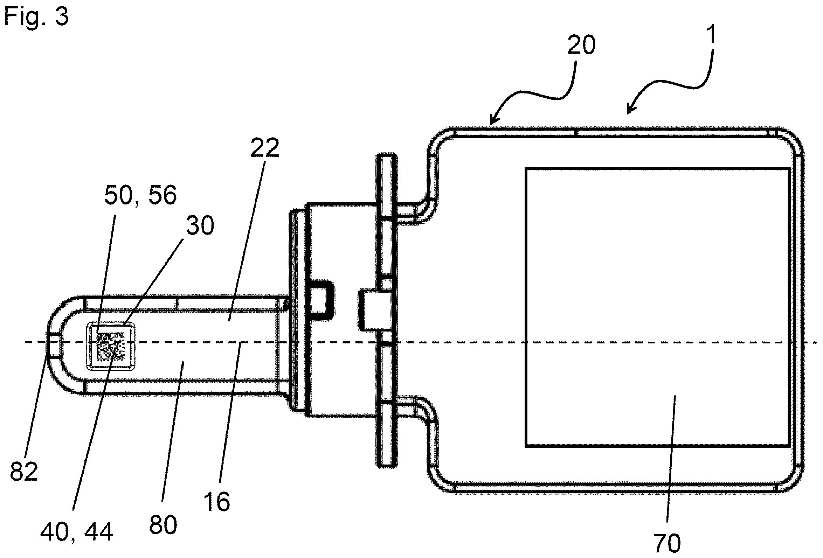

Furthermore, Fig. 3 shows a further embodiment of a sensor device 1 according to the present invention. As described before, the device comprises a housing 20 enclosing a circuit board 50 having a marking 40 and a sensor (not shown) mounted on the circuit board 50.

Particularly, the housing 20 comprises a protrusion or finger 80 formed by a first part of the housing 20 and a base section or second part 70 of the housing 20, wherein said finger 80 protrudes from the second part 70 of the housing 20 in the direction of an e.g. longitudinal axis 16 of the finger 80.

Particularly, the two parts 70, 80 are connected to one another in a releasable fashion.

According to a preferred embodiment, the first part 80 of the housing 20 is formed by a hot melt compound (e.g. as described herein using stamps) while the second part 70 of the housing is an injection-molded second part 80.

Particularly, here, the first opening 30 is formed into a first side 22 (e.g. a back side of the housing 20) of the finger 80 such that a marking 40 arranged on the printed circuit board 50 (e.g. on a back side 56 of the printed circuit board 50) is visible from an outside of the housing 22 /finger 80 particularly when viewing in the direction of the normal. The finger 80 further comprises a second opening arranged on the second side (e.g. front side, not shown) of the housing 20 for allowing the sensor to contact the atmosphere surrounding the device 1, wherein the second opening is preferably aligned with the first opening 30 in a direction perpendicular to the axis 16.

Particularly, in an embodiment, the finger 80 can be formed narrower and/or thinner than the base section / second part 70 of the housing 20. Particularly, the finger 80 comprises a free end section forming an end or a tip 82 of the finger 80, which end/tip 82 is located opposite to the side of the finger 80 that is connected to the second part 70 of the housing 20. Particularly, the two openings 30, 32 are arranged on said end section of the finger 80.

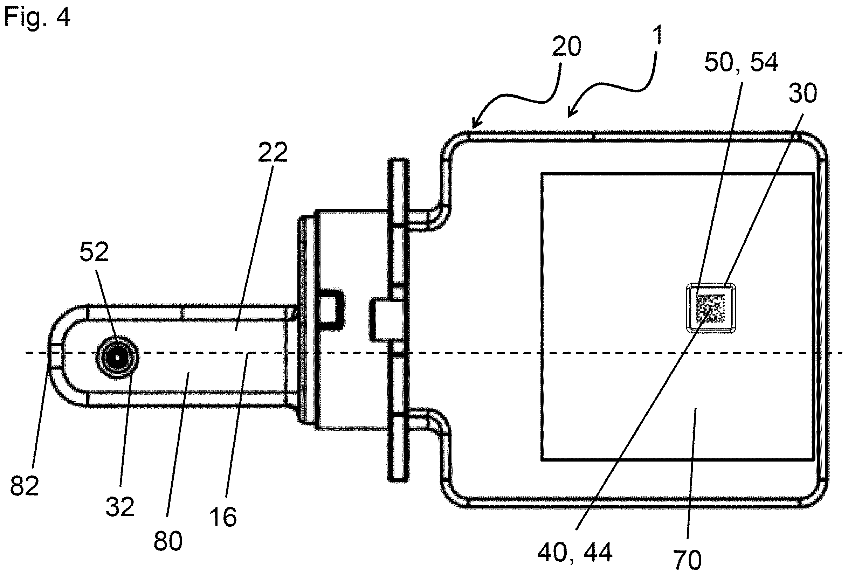

Fig. 4 shows an alternative embodiment. Here, in contrast to Fig. 4, the first opening 30 is arranged in the second part 70 of the housing 20 on the first side 22 (e.g. back side) of the housing 20, particularly in a recess of the second part 70, while the second opening 32 for the sensor 52 is arranged on said end section of the finger 80 on the second first 22 (e.g. back side) of the finger 80/housing 20.

### List of reference numerals

- 1: sensor device
- 3: base section
- 5: connecting section
- 6: electric contact
- 10: central axis
- 14: normal
- 16: axis
- 20: housing
- 22: first (e.g. back) side of the housing
- 24: second (e.g. front) side of the housing
- 26: lateral wall
- 30: first opening
- 32: second opening
- 34: inner boundary
- 36: outer boundary
- 40: marking
- 44: two-dimensional code
- 46: alphanumerical character
- 50: circuit board
- 52: sensor
- 54: first (e.g. front) side of the circuit board
- 56: second (e.g. back) side of the circuit board
- 70: base section, second part
- 80: protrusion/finger, first part
- 82: tip of end section
- 100: area facing the marking
- 102: viewing position
- A: marking area
- B: area of at least one first opening
- X: width of marking area
- Y: height of marking area

## Claims

1. A sensor device (1), comprising:
- a printed circuit board (50),
- at least one sensor (52) arranged on the printed circuit board (50),
- a housing (20) covering at least a part of the printed circuit board (50),
**characterized in that**
the printed circuit board comprises a marking (40) coding information, wherein the marking (40) occupies a marking area (A) on a surface (50a) of the printed circuit board (50), and wherein the housing (20) comprises at least a first opening (30) designed such that the marking (40) is visible from an outside of the housing (20) through the at least one first opening (30), and wherein the at least one first opening (30) extends over an area (B) that is smaller than ten times the marking area (A) or that is equal to ten times the marking area (A).

2. The sensor device (1) according to claim 1, **characterized in that** at least a portion of the housing (20) is formed out of a filling compound, wherein said at least one opening (30) is formed in said portion.

3. The sensor device (1) according to claims 2, **characterized in that** the filling compound comprises or is one of the following materials: a hot melt, a UV-curable adhesive, an injection molding compound.

4. The sensor device (1) according to one of the claims 1 to 3, **characterized in that** the at least one sensor (52) is arranged adjacent the marking (40), wherein the at least one first opening (30) is configured to also provide access for the at least one sensor (52) to an atmosphere outside the housing (20).

5. The sensor device (1) according to one of the claims 1 to 3, **characterized in that** the housing (20) comprises a second opening (32) configured to provide access for the at least one sensor (52) to an atmosphere outside the housing (20).

6. The sensor device (1) according to one of the preceding claims, **characterized in that** the housing (20) comprises a first side (22) and a second side (24), wherein said first side (22) and said second side (24) of the housing (20) face away from each other, and wherein
the at least one first opening (30) is formed in the first side (22) and/or wherein the second opening (32) is formed in the first side (22).

7. The sensor device (1) according to one of the claims 1 to 5, **characterized in that** the housing (20) comprises a first side (22) and a second side (24), wherein said first side (22) and said second side (24) of the housing (20) face away from each other, and wherein the at least one first opening (30) is formed in the first side (22) of the housing (20) and the second opening (32) is formed in the second side (24) of the housing (20).

8. The sensor device (1) according to one of the preceding claims, **characterized in that** the at least one sensor (52) is configured to measure a humidity and/or a temperature and/or a gas concentration.

9. The sensor device (1) according to one of the preceding claims, **characterized in that** the marking (40) is a machine-readable marking.

10. The sensor device (1) according to one of the preceding claims, **characterized in that** the marking (40) comprises an alphanumerical character (46) and/or a one-dimensional code, in particular a bar code, and/or a two-dimensional code (44).

11. The sensor device (1) according to one of the preceding claims, **characterized in that** at least a part of the marking (40) is generated by means of a laser.

12. The sensor device (1) according to one of the preceding claims, **characterized in that** the sensor device (1) comprises a transparent cover element arranged in the at least one first opening such that the marking (40) is visible from an outside of the housing (20) through the cover element.

13. The sensor device according to one of the preceding claims, **characterized in that** the at least one first opening (30) extends over an area (B) that is smaller than five times the marking area (A) or that is equal to five times the marking area (A), and wherein particularly the at least one first opening (30) extends over an area (B) that is smaller than three times the marking area (A) or that is equal to three times the marking area (A).

14. A method for producing a sensor device (1), particularly according to one of the preceding claims, the method comprising the steps of:
- providing a printed circuit board (50) comprising a marking (40) that codes an information,
- arranging at least one sensor (52) on the printed circuit board (50), and
- covering at least a part of the printed circuit board with a housing (20) comprising at least a first opening (30) such that the marking (40) is visible from an outside of the housing (20) through the at least one first opening (30).
